**Europäisches Patentamt**

**European Patent Office**

**Office européen des brevets**

(19)

(11) **EP 1 132 944 A2**

(12) **EUROPÄISCHE PATENTANMELDUNG**

(43) Veröffentlichungstag:
**12.09.2001 Patentblatt 2001/37**

(51) Int Cl.⁷: $H01J\ 37/304$, $H01J\ 37/317$

(21) Anmeldenummer: **01104868.3**

(22) Anmeldetag: **28.02.2001**

(84) Benannte Vertragsstaaten:
**AT BE CH CY DE DK ES FI FR GB GR IE IT LI LU MC NL PT SE TR**
Benannte Erstreckungsstaaten:
**AL LT LV MK RO SI**

(30) Priorität: **08.03.2000 DE 10011202**

(71) Anmelder: **Leica Microsystems Lithography GmbH**
**07745 Jena (DE)**

(72) Erfinder:
• **Plontke, Rainer, Dr.**
**99441 Göttern (DE)**

• **Stolberg, Ines**
**7743 Jena (DE)**
• **Blume, Michael**
**7749 Jena (DE)**
• **Käbsch, Rainer**
**7751 Rothenstein (DE)**
• **Zierbock, Matthias**
**7616 Graitschen (DE)**

(74) Vertreter: **Reichert, Werner F., Dr.**
**Leica Microsystems AG,**
**Corporate Patents + Trademarks Department,**
**Ernst-Leitz-Strasse 17-37**
**35578 Wetzlar (DE)**

(54) **Verfahren zur Ausrichtung eines Elektronenstrahls auf eine Zielposition an einer Substratoberfläche**

(57) Die Erfindung bezieht sich auf das Gebiet der Elektronenstrahl-Lithographie, insbesondere auf ein Verfahren zur Ausrichtung eines Elektronenstrahls (6) auf eine Zielposition (Z) an der Oberfläche eines Substrates, wobei zunächst das Substrat auf einen verfahrbaren Tisch (2) abgelegt wird, dann der Tisch (2) in den Koordinaten X und/oder Y eines kartesischen Rasters schrittweise soweit verschoben wird, bis sich die Zielposition (Z) in einem Abstand vom Auftreffort (P) des nicht-abgelenkten Elektronenstrahls (6) befindet, der kleiner ist als die kleinste Schrittweite der Tischverschiebung und danach der Elektronenstrahl (6) durch Ablenkung auf die Zielposition (Z) gerichtet wird.

Hierdurch wird eine erhebliche Steigerung der Positioniergenauigkeit bei der Elektronenstrahl-Lithographie erzielt. Positioniergenauigkeiten in der Größenordnung von 0,1nm bis 0,05nm sind erreichbar. Das Verfahren eignet sich besonders zum Schreiben von Gittermustern, bei denen der Abstand zwischen den einzelnen Gitterlinien hochgenau eingehalten werden muß.

Fig.1

**EP 1 132 944 A2**

**Beschreibung**

Die Erfindung bezieht sich auf das Gebiet der Elektronenstrahl-Lithographie, insbesondere auf ein Verfahren zur Ausrichtung des Elektronenstrahls auf eine Zielposition an der Oberfläche eines Substrates, wobei zunächst das Substrat auf einen verfahrbaren Tisch (2) abgelegt und dann der Tisch in den Koordinaten X und/oder Y eines kartesischen Rasters schrittweise in vorgegebene Positionen verschoben wird.

Derartige Verfahren werden genutzt, um linien- oder flächenförmige Muster auf die strahlungsempfindliche Resistschicht von Substraten zu schreiben, die dann beispielsweise als Phasenmasken für die Chipherstellung verwendet werden können.

Bei herkömmlichen Verfahren erfolgt die Ausrichtung des Elektronenstrahls auf die Zielposition entweder durch eine Umsetzung von Ortsinformationen über den Zielpunkt in eine Ablenkung des Elektronenstrahls oder durch Zustellung eines schrittweise verfahrbaren Tisches, der das Substrat trägt.

So ist beispielsweise aus Microelectronic Engineering 27 (1995) 135-138 eine Vorrichtung zur Elektronenstrahl-Lithographie bekannt, bei der das Substrat mittels eines Tisches gegenüber einem annähernd stationären Elektronenstrahl positioniert wird. Diese Vorrichtung erlaubt eine Positioniergenauigkeit des Tisches und damit der Zielposition relativ zum Elektronenstrahl von etwa 10nm bis 2,5nm. Eine weitere Erhöhung der Positioniergenauigkeit des Tisches ist nur mit erheblichem feingerätetechnischen Aufwand möglich.

In der Praxis werden jedoch für besondere Fälle Positioniergenauigkeiten benötigt, die außerhalb der Genauigkeiten liegen, die selbst bei höchstem Aufwand mit einem schrittweise verfahrbaren Tisch erreichbar sind. Ein Beispiel hierfür ist die Herstellung von Phasenmasken für gechirpte Bragg-Gitter (Fiber-Bragg-Gratings), wofür Positioniergenauigkeiten von mindestens 0,1nm bis 0,05nm erforderlich sind; diese Genauigkeit muß zudem über einen Zustellbereich von etwa 150mm zur Verfügung stehen.

Bei einem solchen Gitter mit einer Gitterperiode von 1 $\mu$m und einer Breite von 100 mm sind 100.000 parallele Gitterlinien in hochgenauer Anordnung zueinander aufzubringen. Die Besonderheit bei gechirpten Gittern besteht darin, daß der Abstand zwischen den zwei letzten Gitterlinien zum Beispiel um 0,5nm größer sein soll als der Abstand zwischen den beiden ersten Gitterlinien. Weiterhin soll der Abstand zwischen benachbarten Gitterlinien von den beiden ersten Gitterlinien zu den beiden letzten Gitterlinien linear zunehmen. Theoretisch folgt hieraus, daß der Abstand zwischen zwei benachbarten Gitterlinienpaaren um jeweils 0,005pm zunehmen muß. Diese Differenz liegt in der Größenordnung des Bruchteils eines Atomdurchmessers und kann demzufolge gerätetechnisch nicht verwirklicht werden.

Auf die exakte Position der Gitterlinie kommt es jedoch angesichts der großen Anzahl von Gitterlinien nicht an, da das Gitter kollektiv wirkt. Vielmehr darf die reale Position der Gitterlinien um die theoretische Sollposition statistisch schwanken, ohne daß damit die Gesamtfunktion des Gitters bereits verloren ginge. Bei Zugrundelegung einer Gauß'schen Verteilung der Schwankung wären schon 1$\sigma$-Werte von weniger als 2nm durchaus zulässig.

Die Funktion des gechirpten Gitters geht jedoch verloren, wenn an den Gitterlinien systematische Positionsabweichungen auftreten oder viele Gitterlinien um den gleichen Betrag versetzt sind.

Theoretische Berechnungen haben ergeben, daß eine ausreichende Funktion eines gechirpten Gitters gerade noch erreicht wird, wenn das Gitter in Linienpakete von jeweils nicht mehr als 200 Gitterlinien zerlegt wird und die mittlere Gitterkonstante von Paket zu Paket dann um den Wert abnimmt, wie er sich unter den obigen Voraussetzungen für 200 Stäbe ergeben würde, nämlich hier um 1pm ($10^{-12}$m). Diese Veränderung kann erzeugt werden, indem im jeweils folgenden Paket der Abstand lediglich eines Linienpaares um einen Schritt bzw. ein Inkrement eines bei dessen Herstellung verwendeten Positioniersystems vermindert wird. Die Schrittweite bzw. das Inkrement des Positioniersystems müßte dann etwa 0,2nm betragen. Dies ist mit den bisher bekannten Vorrichtungen zur Elektronenstrahl-Lithographie jedoch nicht realisierbar.

Zur Herstellung eines Gitters mit der oben genannten Funktion ist es weiterhin bekannt, dieses zunächst in eine Vielzahl von hintereinander geschalteten Arbeitsfeldern aufzuteilen, die jeweils eine vorgegebene Anzahl von Gitterlinien, beispielsweise 500 Gitterlinien bei einer Feldgröße von 500$\mu$m, aufweisen. Die Arbeitsfelder werden nun in ihrer Größe skaliert, wobei der Größenunterschied zwischen zwei benachbarten Arbeitsfeldern etwa 1,25nm beträgt. Bei einem solchen Gitter weisen alle Linien in einem Arbeitsfeld theoretisch den gleichen Abstand auf. Am Übergang zu einem benachbarten Arbeitsfeld, d.h. nach jeweils 500 Linien, springt der Linienabstand theoretisch um 2,5pm.

Problematisch ist hierbei vor allem die genaue Montage der Arbeitsfelder hintereinander, da die Montagegenauigkeit von herkömmlichen Vorrichtungen zur Elektronenstrahl-Lithographie im Nanometerbereich liegt. Montagefehler zwischen den Arbeitsfeldern machen sich jedoch als systematische Fehler durch Überstrukturen im Gitter bemerkbar. Weitere systematische Verzerrungen des Gitters resultieren aus Restverzeichnungen des Arbeitsfeldes, so daß sich die Verzerrungen mit der Periodizität der Arbeitsfelder wiederholen.

Davon ausgehend liegt der Erfindung die Aufgabe zugrunde, die Positioniergenauigkeit bei der Elektronenstrahl-Lithographie weiter zu verbessern.

Diese Aufgabe wird gelöst mit einem Verfahren zur Ausrichtung eines Elektronenstrahls auf eine Zielposition an der Oberfläche eines Substrates, wobei zunächst das Substrat auf einen in einem kartesischen Raster in den Koordinaten X und Y schrittweise verfahrbaren Tisch abgelegt wird, dann der Tisch soweit verschoben wird, bis sich die Zielposition in einem Abstand vom Auftreffort des nicht-abgelenkten Elektronenstrahls befindet, der kleiner ist als die kleinste Schrittweite der Tischverschiebung und danach der Elektronenstrahl durch Ablenkung auf die Zielposition gerichtet wird.

Mit dem erfindungsgemäßen Verfahren lassen sich durch die Aufteilung der Positionseinstellung auf zwei Positioniersysteme, nämlich die Positionierung erstens mit der Tischverstellung und zweitens mit dem Strahlablenksystem, Genauigkeiten von bis zu 0,05nm erreichen. Ein Gitter mit der Funktion des oben beschriebenen gechirpten Bragg-Gitters kann damit problemlos und in hoher Güte an einem Substrat ausgebildet werden.

Dabei ist das erfindungsgemäße Verfahren nicht auf die Herstellung eines solchen Gitters beschränkt. Vielmehr eignet es sich für alle Anwendungen, bei denen es auf eine extreme Feineinstellung des Zielpunktes an der Substratoberfläche ankommt. Ein bevorzugtes Anwendungsgebiet ist das Schreiben von linien- oder flächenartigen Mustern für Phasenmasken. Weiterhin kann das Verfahren auch zur Direktbelichtung solcher Muster auf Halbleitersubstrate eingesetzt werden.

Die Aufteilung der Positionierung auf zwei in Reihe geschaltete Positioniersysteme erlaubt überdies die Verwendung eines in herkömmlicher Art und Weise betriebenen Substrattisches zur Grobeinstellung der Zielposition, welche von der Feineinstellung mittels Ablenkung des Elektronenstrahls örtlich getrennt ist. Der apparative Aufwand kann damit trotz der Steigerung der Positioniergenauigkeit verhältnismäßig gering gehalten werden.

Bevorzugt liegt die Schrittweite des verfahrbaren Tisches im Bereich von 1nm bis 10nm, besonders bevorzugt bei 2,5nm, d.h. sie liegt im Genauigkeitsbereich herkömmlicher Vorrichtungen für die Elektronenstrahl-Lithographie, die damit in einfacher Weise durch entsprechende Konfiguration der Systemsteuerung um das erfindungsgemäße Verfahren erweitert werden können.

In einer vorteilhaften Ausgestaltung wird die Ablenkung des Elektronenstrahls auf einen Bereich von $\pm 3\,\mu m$ bis $\pm\,6\,\mu m$ skaliert. Der Ablenkbereich des Elektronenstrahls ist somit auf einen sehr engen Teilbereich an dem Substrat beschränkt, in dem dann bei moderatem Hardwareaufwand eine sehr hohe Adressier- und Arbeitsgenauigkeit für die Feinpositionierung zur Verfügung steht. Die Positioniergenauigkeit wird in beiden Koordinaten X, Y der Bewegungsebene des Tisches erreicht, so daß auch nicht-geradlinige Muster sehr genau geschrieben werden können. Es ist für eine sehr hochgenaue Adressierung der Zielposition auch denkbar, den Ablenkbereich auf die Schrittweite eines einzelnen Inkrementes des Tisches zu skalieren.

Zum Schreiben von parallelen Gitterlinien wird in einer zu diesem Zweck besonders vorteilhaften Ausgestaltung der Tisch in den Koordinaten X **und** Y einer Ebene schrittweise verfahren. Die Ablenkung des Elektronenstrahls ist dabei lediglich in einer der Koordinaten X **oder** Y auf einen Bereich von $\pm 3\mu m$ bis $\pm\,6\mu m$ skaliert. Dies erlaubt eine hochgenaue Einstellung des besonders empfindlichen Abstandes der Gitterlinien untereinander. Andererseits bleibt der Aufwand für die weniger kritische Einstellung von Veränderungen der Zielposition in Längsrichtung der Gitterlinien nach einer einmal erfolgten Einstellung des Linienabstandes, d.h. der Koordinate quer zu den Gitterlinien, gering. Die Zeitdauer für das Schreiben des Gitters kann somit ebenfalls gering gehalten werden. Das Schreiben von Linien in deren Längsrichtung erfolgt in einfacher Art und Weise über die Zustellung des Tisches in der betreffenden Koordinate X oder Y.

In einer alternativen Ausführungsvariante hingegen wird mit der Ablenkung des Elektronenstrahls auch in Längsrichtung der Gitterlinien gearbeitet, die in dieser Koordinate für einen effizienten Hardwareeinsatz und eine schnelle Schreibgeschwindigkeit dann bevorzugt auf einen größeren Bereich von $\pm18\mu m$ bis $\pm180\mu m$ skaliert ist.

In einer weiteren vorteilhaften Ausgestaltung der Erfindung wird die Ablenkung des Elektronenstrahls mit einer Auflösung von 16 Bit vorgenommen. Damit kann eine schnelle Umschaltung zwischen unterschiedlich skalierten Ablenkbereichen des Elektronenstrahls bewirkt werden, wobei mit kleiner werdenden Ablenkbereichen eine feinere Auflösung in Weggrößen erzielt wird. Folglich lassen sich auch sehr genau berechnete Zielpositionen in ein entsprechend präzises Ablenksignal für den Elektronenstrahl umsetzen.

Die Erfindung wird nachfolgend anhand von in der Zeichnung dargestellten Ausführungsbeispielen näher erläutert. Die Zeichnung zeigt in

Fig.1     eine schematische Darstellung einer Vorrichtung zur Elektronenstrahl-Lithographie,

Fig.2     eine vergrößerte Darstellung der Umgebung des Auftreffortes des Elektronenstrahls auf das Substrat,

Fig.3     eine Darstellung zur Veranschaulichung eines ersten Verfahrens zum Schreiben eines Gitters auf ein Substrat, und in

Fig.4     eine Darstellung zur Veranschaulichung eines weiteren Verfahrens zum Schreiben eines Gitters auf ein Substrat.

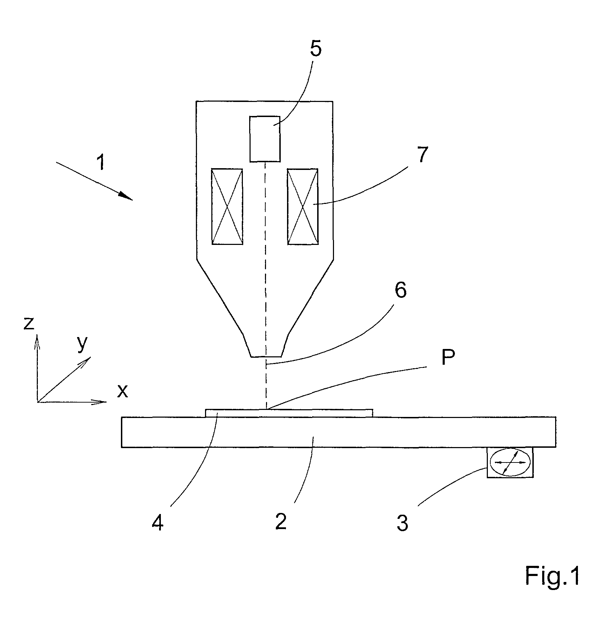

Die Vorrichtung zur Elektronenstrahl-Lithographie 1 in Fig.1 umfaßt einen in den Koordinatenrichtungen X und Y verfahrbaren Tisch zur Halterung eines flächenhaften, sich überwiegend in der X-Y-Ebene erstreckenden Substrats 4. Der Tisch 2 ist über eine zugeordnete Zustelleinrichtung 3 in der X-Koordinate wie auch in der Y-Koordinate schrittweise verschiebbar, um das Substrat relativ zu einem Elektronenstrahl positionieren zu können. Hierbei liegen die einzelnen Zustellschritte bzw. Einzelinkremente für jede der Koordinatenrichtungen X und Y in der Größenordnung von 1nm bis 10nm. Die Zustellgeschwindigkeit beträgt etwa 1mm/s. In dem gewählten Ausführungsbeispiel wird eine Einzelschrittweite von 2,5nm verwendet.

Die Vorrichtung zur Elektronenstrahl-Lithographie 1 umfaßt weiterhin eine Elektronenstrahlungsquelle 5, die einen gebündelten Elektronenstrahl 6 mit im wesentlichen konstanter Strahlungsdichte in Richtung der Koordinate Z senkrecht zu der von den Koordinaten X und Y aufgespannten Ebene auf den Tisch 2 bzw. das Substrat 4 richtet. Die Elektronenstrahlungsquelle 5 ist beispielsweise eine Feldemissionskathode, die sich durch eine hohe Konstanz der Strahlungsdichte des abgegebenen Elektronenstrahls 6 auszeichnet.

Der Elektronenstrahlungsquelle 5 ist eine elektromagnetische Ablenkeinrichtung 7 zur Ablenkung des Elektronenstrahls 6 beigeordnet. Mit dieser kann der Elektronenstrahl 6 sowohl in Richtung der X-Koordinate als auch in Richtung der Y-Koordinate abgelenkt werden. Fig.1 zeigt den Elektronenstrahl 6 in seiner nicht-abgelenkten Ausrichtung senkrecht zu der Oberfläche des Substrats 4 bzw. der Oberfläche des Tisches 2.

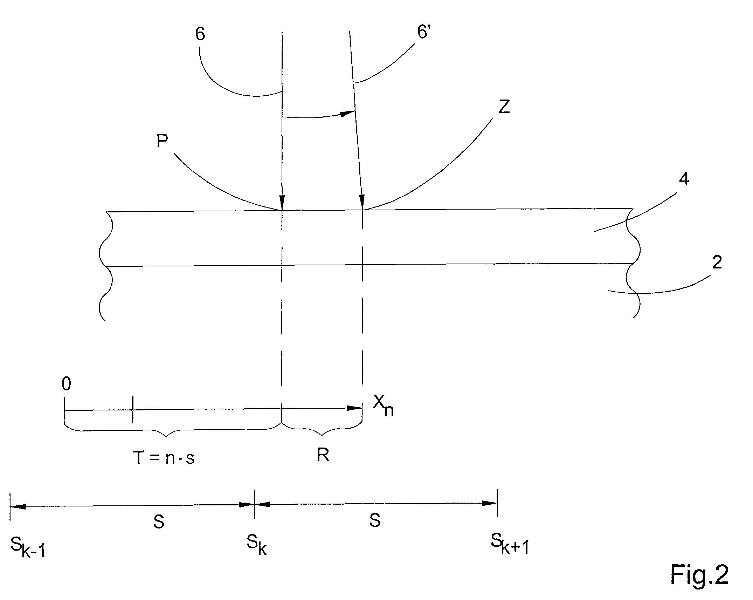

Die Verhältnisse um den Auftreffort des Elektronenstrahls 6 an der Oberfläche des Substrats 4 sind in Fig.2 im Detail dargestellt. Wie bereits erläutert, ist der Tisch 2 in seinen Koordinatenrichtungen X und Y jeweils schrittweise verstellbar. Fig.2 veranschaulicht die Verstellmöglichkeiten in Richtung der X-Koordinate, wobei die einzelnen Fortschaltpunkte der Zustelleinrichtung 3 für den Tisch 2 in X-Richtung mit $S_k$ bezeichnet sind. Hierbei ist k ein ganzzahliger Zählindex. Das Inkrement zwischen unmittelbar benachbarten Fortschaltpunkten, d.h. die Schrittweite s der Zustellvorrichtung 3 in X-Richtung ist konstant. Sie beträgt hier, wie bereits oben erwähnt, 2,5nm.

Der Auftreffort P des Elektronenstrahls 6 an der Oberfläche des Substrates 4 ist mittels der Ablenkvorrichtung 7 mindestens über die Schrittweite s eines Einzelschrittes der Zustelleinrichtung 3 bewegbar. Zur Feinpositionierung des Auftreffortes P in einem Zielpunkt Z an dem Substrat 4 wird die gesamte Auflösung der Ablenkeinrichtung 7 auf einen kleinen Oberflächenbereich skaliert, so daß sich eine Auflösung von 0,1nm oder auch von 0,05nm ergibt.

In den dargestellten Ausführungsbeispielen erfolgt die Ansteuerung der Ablenkeinrichtung 7 mit einer 16-Bit-Auflösung. Mit den oben genannten Weggrößen für die Auflösung ergibt sich an der Substratoberfläche dann ein Ablenkbereich von ±6µm bzw. ±3µm. Eine Ablenkung des Elektronenstrahls 6 aus der nicht-abgelenkten Position in eine abgelenkte Position, die in Fig.2 mit dem Bezugszeichen 6' angedeutet ist, kann folglich mit hoher Präzision adressiert und eingestellt werden.

Zur Ausrichtung des Elektronenstrahls 6 auf einen Zielpunkt Z an der Oberfläche des Substrats 4 sei zunächst angenommen, daß an dem Substrat 4 ein Relativkoordinatensystem zum Tisch 2 etabliert worden sei, und daß weiterhin die Weglänge $X_n$ einer Verschiebungskomponente in Richtung der X-Koordinate in den Relativkoordinaten des Substrates 4 bekannt sei. Zu der bekannten Weglänge $X_1$ wird dann das nächstliegende ganzzahlige Vielfache T der Schrittweite s der Tisch-Zustelleinrichtung 3 gesucht. Weiterhin wird der verbleibende Abstand R zwischen der Weglänge $X_n$ und dem ganzzahligen Vielfachen T der Schrittweite s ermittelt. Es gilt:

$$X_n = T + R \text{ und } T = n \cdot s,$$

wobei n für die Anzahl der Einzelschritte steht.

Hiernach wird die Zustelleinrichtung 3 des Tisches 2 um die ermittelte Anzahl n von Einzelschritten s weitergeschaltet, so daß sich danach der Auftreffort P des nicht-abgelenkten Elektronenstrahls 6 im geringstmöglichen Abstand zu der eigentlichen Zielposition Z befindet. Der verbleibende Abstand R wird anschließend mittels der Ablenkeinrichtung 7 durch eine schrittweise Feineinstellung des Elektronenstrahls ausgeglichen. In dem dargestellten Ausführungsbeispiel entspricht ein Einzelinkrement der Ablenkeinrichtung 7 je nach Skalierung 0,1nm oder 0,05nm. Eine derartige Auflösung setzt selbstverständlich voraus, daß die Positionen der Zielpunkte Z mindestens mit einer entsprechenden Genauigkeit berechnet werden.

Bei der vorstehend beschriebenen Vorgehensweise wird der nicht-abgelenkte Elektronenstrahl 6 sowohl um positive wie auch um negative Winkel abgelenkt, um die Feinpositionierung des Auftreffortes P in dem Zielpunkt Z an der Substratoberfläche zu bewirken. Der maximal auszugleichende Abstand R in der X-Koordinate ist dann auf die Hälfte eines Einzelschrittes der Tisch-Zustelleinrichtung 3 beschränkt.

In einer Ausführungsvariante ist es auch möglich, bei der Aufteilung der einzustellenden Weglänge $X_n$ stets das nächstkleinere ganzzahlige Vielfache T der Schrittweite s zu ermitteln und dann ausgehend von diesem den restlichen Abstand R zu bestimmen. In diesem Fall entspricht die maximale Ablenkung des Elektronenstrahls 6 einer Wanderung des Auftreffortes P um eine Schrittweite s der Tisch-Positioniereinrichtung 3. Die Ablenkung des Elektronenstrahls 6 zur Feineinstellung wird jedoch dann stets in die gleiche Richtung vorgenommen. Überdies ist ein Rechenalgorithmus zur Bestimmung des nächstkleineren Wertes T etwas kürzer als ein Algorithmus zur Bestimmung des nächstliegenden Wertes T.

In einer weiteren Ausführungsvariante kann auch stets von dem nächstgrößeren ganzzahligen Vielfachen T der Einzelschrittlänge der Zustelleinrichtung 3 ausgegangen werden, wobei dann der verbleibende Abstand R eine Ablenkung des Elektronenstrahls 6 in die umgekehrte Richtung erfordert.

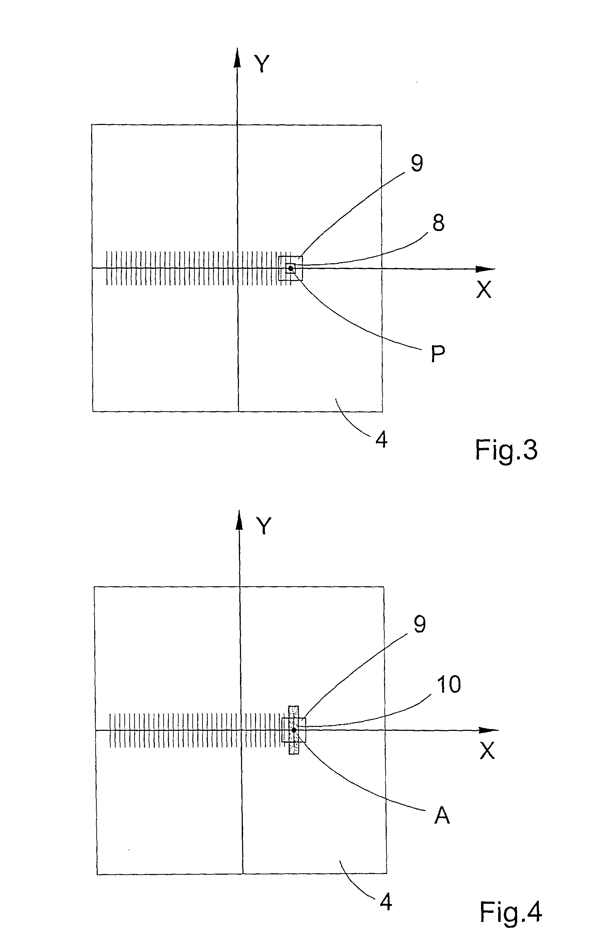

Fig.3 veranschaulicht eine Vorgehensweise zum Schreiben von Gitterlinien auf ein Substrat 4. Die einzelnen Gitterlinien erstrecken sich hier jeweils parallel zu der Y-Koordinate und sind in X-Richtung parallel hintereinander angeordnet.

Für das Schreiben einer Gitterlinie wird zunächst die X-Koordinate der betreffenden Linie angefahren, wozu in der oben bereits erläuterten Art und Weise zunächst die Zustellung des Tisches 2 erfolgt. Bei dem Ausführungsbeispiel nach Fig.3 beträgt der Fahrbereich des Tisches 2 in den beiden Koordinatenrichtungen X und Y jeweils etwa ±80mm. Dieser Fahrbereich ist für jede Koordinate in Einzelschritte mit einer Schrittlänge von 2,5nm aufgelöst.

Der verbleibende Abstand R zu dem X-Wert der Zielposition der betreffenden Gitterlinie wird mittels der Ablenkeinrichtung 7 eingestellt. Der Ablenkbereich des Elektronenstrahls ist in Fig.3 durch das Feld 8 um den Auftreffpunkt P des nichtausgelenkten Elektronenstrahls 6 dargestellt. Die Feldgröße beträgt hier in beiden Koordinaten X und Y je nach Skalierung ±3μm oder ± 6μm.

Nach der Positionierung in X-Richtung wird der Tisch 2 mit dem Substrat 4 mittels der Zustelleinrichtung 3 in Y-Richtung verschoben, um die Gitterlinie zu schreiben. Hierbei wandert der Tisch 2 unter dem in Y-Richtung in erster Näherung festgehaltenen Elektronenstrahl 6 hindurch. Etwaige Abweichungen der realen Position des Tisches 2 bzw. des Substrates 4 von der theoretischen Sollposition werden gemessen, beispielsweise mit einem Laserinterferometer, und einem Beam-Tracking-System zugeführt, mit Hilfe dessen auftretende Abweichungen durch eine zusätzliche Ablenkung des Elektronenstrahls 6 ausgeglichen werden. Hierbei bilden die Tisch-Zustelleinrichtung 3 und das Beam-Tracking-System eine in sich geschlossene Einheit, wobei die einzelnen Komponenten zueinander kalibriert sind. In Fig.3 ist der Ablenkbereich des Beam-Tracking-Systems durch das Feld 9 veranschaulicht. Dieser beträgt in dem Ausführungsbeispiel ±18μm bei einer Auflösung von 2,5nm.

Nach dem Schreiben einer Gitterlinie wird das Substrat 4 in Richtung der X-Koordinate versetzt. Anschließend kann die nächste Gitterlinie geschrieben werden.

Eine weitere Vorgehensweise wird nun anhand von Fig.4 kurz erläutert. Diese unterscheidet sich von der im Zusammenhang mit Fig.3 beschriebenen Vorgehensweise im wesentlichen dadurch, daß zur Erzeugung einer Relativbewegung in der Y-Koordinate zwischen dem Elektronenstrahl 6 und dem Substrat 4 nunmehr nicht der Tisch 2 mit dem Substrat 4 verfahren wird, sondern vielmehr der Elektronenstrahl 6 hierzu in Y-Richtung abgelenkt wird. Der Ablenkbereich der Ablenkeinrichtung 7 wird dann in Y-Richtung in etwa auf die Länge einer Gitterlinie, beispielsweise ± 90μm skaliert, wohingegen in X-Richtung eine Skalierung in der obengenannten Größenordnung ±3μm bis ±6μm beibehalten wird. Somit ergibt sich für den Ablenkbereich der Ablenkeinrichtung 7 in Fig.4 ein langgestrecktes Rechteckfeld 10, wobei hier zu beachten ist, daß in Fig.3 und Fig.4 die Darstellung der Gitterlinien wie auch der Felder 8 bis 10 nicht maßstäblich ist.

Auch hier werden etwaige Abweichungen der realen Position des Substrates 4 bzw. des Tisches 2 durch ein auf den Elektronenstrahl 6 einwirkendes und diesen zusätzlich ablenkendes Beam-Tracking-System ausgeglichen. Zum Schreiben einer weiteren Linie wird zunächst deren neue X-Koordinate in der oben bereits erläuterten Art und Weise eingestellt. Das eigentliche Schreiben der Linie erfolgt dann wiederum durch eine Auslenkung des Elektronenstrahls 6 in Y-Richtung.

Bei beiden Vorgehensweisen werden die Gitterlinien quasi kontinuierlich hintereinanderweg geschrieben, so daß beispielsweise die eingangs erläuterten Probleme bei der Montage von hintereinander angeordneten Arbeitsfeldern vollständig entfallen. Aufgrund der gesonderten Ansteuerung der Zielpunkte und der gleichbleibend hohen Positioniergenauigkeit in der Größenordnung bis hinab zu 0,05nm kann das Auftreten systematischer Lageabweichungen stark vermindert werden.

Die zuvor beschriebenen Verfahren eignen sich besonders zum Schreiben von Gittern mit parallelen Linien, wobei die unterschiedlichen Genauigkeitserfordernisse längs der Gitterlinien, d.h. in Y-Richtung und quer zu den Gitterlinien, d.h. in X-Richtung ausgenutzt werden, um den Adressier- und Positionieraufwand möglichst gering zu halten. Es ist jedoch auch möglich, nicht nur in X-Richtung, sondern auch in Y-Richtung die Positionierung auf zwei jeweils in Reihe geschaltete Positioniersysteme aufzuteilen, wozu dann in Y-Richtung in gleicher Weise vorgegangen wird, wie dies hier anhand von Fig.2 in bezug auf die X-Richtung erläutert wurde.

**Bezugszeichenliste**

| | |
|---|---|
| 1 | Vorrichtung zur Elektronenstrahl-Lithographie |
| 2 | Tisch |
| 3 | Zustelleinrichtung |
| 4 | Substrat |
| 5 | Elektronenstrahlungsquelle |
| 6 | Elektronenstrahl |
| 7 | Ablenkeinrichtung |
| 8 | Feld |
| 9 | Feld |
| 10 | Feld |
| | |
| k | Zählindex |
| s | Schrittweite |

X, Y    Koordinaten
R       Abstand
P       Auftreffort
Z       Zielposition
T       ganzzahliges Vielfaches
$X_n$    Weglänge

**Patentansprüche**

1. Verfahren zur Ausrichtung eines Elektronenstrahls (6) auf eine Zielposition (Z) an der Oberfläche eines Substrates bei der Elektronenstrahl-Lithographie, wobei zunächst das Substrat auf einen verfahrbaren Tisch (2) abgelegt wird, dann der Tisch (2) in den Koordinaten X und/oder Y eines kartesischen Rasters schrittweise soweit verschoben wird, bis sich die Zielposition (Z) in einem Abstand vom Auftreffort (P) des nicht-abgelenkten Elektronenstrahls (6) befindet, der kleiner ist als die kleinste Schrittweite der Tischverschiebung und danach der Elektronenstrahl (6) durch Ablenkung auf die Zielposition (Z) gerichtet wird.

2. Verfahren nach Anspruch 1, **dadurch gekennzeichnet, daß** die Verschiebung des Tisches (2) in den Koordinaten X und Y mit Schrittweiten im Bereich von 1 bis 10 nm, bevorzugt mit einer Schrittweite von 2,5nm vorgenommen wird.

3. Verfahren nach Anspruch 1 oder 2, **dadurch gekennzeichnet, daß** die Ablenkung des Elektronenstrahls (6) auf einen Bereich von $\pm 3\mu m$ bis $\pm 6\mu m$ skaliert ist.

4. Verfahren nach Anspruch 1 oder 2, **dadurch gekennzeichnet, daß** die Ablenkung des Elektronenstrahls (6) in einer der Koordinaten X oder Y auf einen Bereich von $\pm 3\mu m$ bis $\pm 6\mu m$ und in der jeweils anderen Koordinate X oder Y auf einen Bereich von $\pm 18\mu m$ bis $\pm 180\mu m$ skaliert ist.

5. Verfahren nach einem der Ansprüche 1 bis 4, **dadurch gekennzeichnet, daß** die Ablenkung des Elektronenstrahls (6) mit einer Auflösung von 16 Bit vorgenommen wird.

Fig.1

Fig.2

Fig.3

Fig.4